# EUROPÄISCHE PATENTSCHRIFT

(11) **EP 3 016 822 B1**
(45) Veröffentlichungstag und Bekanntmachung des Hinweises auf die Patenterteilung: **13.11.2019**
(21) Anmeldenummer: 14805275.6
(22) Anmeldetag: 28.11.2014
(51) Int. Cl.: H05K 5/02, H05K 5/06

(54) **ABDICHTUNG FÜR EIN GEHÄUSE EINER ELEKTRONISCHEN SCHALTUNGSANORDNUNG, VERFAHREN ZUM ABDICHTEN UND GETRIEBESTEUERUNG**
SEAL FOR A HOUSING OF AN ELECTRONIC CIRCUIT ASSEMBLY, SEALING METHOD AND TRANSMISSION CONTROLLER
JOINT D'ÉTANCHÉITÉ POUR LE BOÎTIER D'UN ENSEMBLE DE CIRCUITS ÉLECTRONIQUES, PROCÉDÉ D'ÉTANCHÉIFICATION ET COMMANDE DE TRANSMISSION

(30) Priorität: 10.12.2013 DE 102013225441
(43) Veröffentlichungstag der Anmeldung: 11.05.2016
(73) Patentinhaber: Conti Temic Microelectronic GmbH, 90411 Nürnberg (DE)
(72) Erfinder: SCHMIDT, Thomas, 93133 Burglengenfeld (DE); SCHUCH, Bernhard, 91616 Neusitz (DE); ZENICHOWSKI, Jan, 91244 Pommelsbrunn (DE)
(74) Vertreter: Bonn, Roman Klemens
(86) Internationale Anmeldenummer: PCT/EP2014/075935
(87) Internationale Veröffentlichungsnummer: WO 2015/086341

(56) Entgegenhaltungen:
- EP-A2- 0 125 619
- WO-A1-2004/084598
- DE-A1- 10 340 974
- DE-A1-102004 018 488
- DE-A1-102007 045 157
- US-A- 5 989 719

## Beschreibung

Die Erfindung betrifft ein Gehäuse für eine elektronische Schaltungsanordnung und ein Verfahren zur Abdichtung eines Gehäuses für eine elektronische Schaltungsanordnung. Ferner betrifft die Erfindung eine Getriebesteuerung und ein Getriebe.

Steuergeräte enthalten in der Regel eine Vielzahl von elektronischen Komponenten, die mit anderen Komponenten außerhalb des Steuergeräts in Verbindung stehen. Zum Schutz vor Umwelteinflüssen und mechanischen Einflüssen werden elektronische Schaltungen von Steuergeräten oft in Gehäuse verbaut. Zur Verbindung derartiger elektronischer Schaltungen mit elektrischen Komponenten außerhalb des Steuergeräts ist daher eine elektrische Durchführung aus dem jeweiligen Gehäuse nötig.

Insbesondere im automobilen Getriebebau werden derzeit Steuerungen für automatische Getriebe sowohl am als auch im Getriebe direkt verbaut. Auch diese Steuerungen sind in der Regel durch Gehäuse geschützt. Die Gehäuse sind jeweils mit entsprechenden Leiterdurchführungen ausgestattet. Zum Schutz der elektronischen Komponenten gegenüber aggressiven Medien, wechselndem Druck und wechselnden Temperaturen im Bereich von -40 bis 150°C werden diese Durchführungen zusätzlich durch geeignete Dichtmittel abgedichtet.

Verbindungen von elektronischen Komponenten, die im Inneren eines Gehäuses angeordnet sind, mit Komponenten außerhalb des Gehäuses können auf unterschiedliche Weise ausgeführt werden. EP 0 375 271 B1 offenbart beispielsweise ein Gehäuse mit einer elektrischen Verbindungsanordnung zur elektrischen Verbindung zwischen einer ersten Verbindungsstelle innerhalb des Gehäuses und einer zweiten Verbindungsstelle außerhalb des Gehäuses, wobei die elektrische Verbindungsanordnung ein elektrisch isolierendes Substrat enthält, welches gegenüber dem Gehäuse an einer Abdichtungszone abdichtet und eine elektrisch leitende Schiene trägt, und wobei das Substrat und die Schiene an der Dichtungszone auf Fluid-dichte Weise gegenüber dem Gehäuse abgedichtet sind.

Der Erfindung liegt die Aufgabe zu Grunde, ein verbessertes Gehäuse für eine elektronische Schaltungsanordnung und ein Verfahren zur Abdichtung eines Gehäuses für eine elektronische Schaltungsanordnung anzugeben. Ferner liegt der Erfindung zu Grunde, eine robustere Getriebesteuerung und ein verbessertes Getriebe anzugeben.

Die Aufgabe wird erfindungsgemäß hinsichtlich des Gehäuses durch die Merkmale des Anspruchs 1, hinsichtlich des Verfahrens durch die Merkmale des Anspruchs 6, hinsichtlich der Getriebesteuerung durch die Merkmale des Anspruchs 7 und hinsichtlich des Getriebes durch die Merkmale des Anspruchs 8 gelöst.

Vorteilhafte Ausgestaltungen der Erfindung sind Gegenstand der Unteransprüche.

Ein erfindungsgemäßes Gehäuse für eine elektronische Schaltungsanordnung weist eine gehäuseinnenseitige Gehäuseabdichtung auf, die stoffschlüssig mit wenigstens einer Gehäuseaußenwand verbunden ist, wobei die Gehäuseabdichtung aus einem Elastomer aus einem Flüssigsilikon besteht. Ein elektrisches Verbindungselement ist vom Gehäuseinneren durch eine Gehäuseaußenwand hindurch aus dem Gehäuse herausgeführt, und ein Spalt zwischen dieser Gehäuseaußenwand und dem elektrischen Verbindungselement ist durch die Gehäuseabdichtung abgedichtet.

Durch das elektrische Verbindungselement kann eine in dem Gehäuse angeordnete elektronische Schaltungsanordnung vorteilhaft mit elektrischen Komponenten außerhalb des Gehäuses verbunden und/oder von außen kontaktiert werden. Die Abdichtung eines Spaltes zwischen der Gehäuseaußenwand und dem elektrischen Verbindungselement verhindert das Eindringen schädlicher Materialien in das Gehäuse. Dabei ist ein elektrisches Verbindungselement beispielsweise als ein Stanzgitter ausgebildet.

Stanzgitter eignen sich aufgrund ihrer einfachen und kostengünstigen Herstellbarkeit und geometrischen Anpassbarkeit besonders gut als elektrische Verbindungselemente.

Unter einem Flüssigsilikon wird hier ein so genanntes Liquid Silicone Rubber (LSR) verstanden, das unter Temperatureinwirkung zu einem Elastomer aushärtet.

Die Gehäuseabdichtung ermöglicht es, eine elektronische Schaltungsanordnung vor schädigenden Umgebungseinflüssen wie beispielsweise Getriebeöl zu schützen und somit beispielsweise in Getrieben anzuordnen. Die Verwendung von Elastomeren mit einer Shore A-Härte im Bereich von 30-80 ermöglicht dabei vorteilhaft, das Gehäuse selbst und Durchführungen für elektrische Verbindungselemente mit dafür jeweils geeigneten Elastomeren abzudichten und dadurch eine besonders gute Abdichtwirkung zu erzielen. Flüssigsilikone eignen sich aufgrund ihrer Materialeigenschaften und flexiblen Verwendbarkeit besonders gut zur Herstellung der Gehäuseabdichtung.

Eine Ausgestaltung der Erfindung sieht vor, dass die Gehäuseabdichtung eine Wandlücke zwischen Gehäuseaußenwänden des Gehäuses abdichtet.

Dadurch können die besonders abdichtungsrelevanten Zonen, in denen Gehäuseaußenwände aneinander grenzen, abgedichtet werden.

Die Erfindung sieht wenigstens eine in dem Gehäuseinneren angeordnete Gehäuseinnenwand vor, die stoffschlüssig mit der Gehäuseabdichtung verbunden ist.

Dadurch können das Gehäuse und die Gehäuseabdichtung vorteilhaft stabilisiert werden.

Die Erfindung sieht vor, dass die Gehäuseabdichtung einen Zwischenraum zwischen einer Gehäuseinnenwand und einer Gehäuseaußenwand wenigstens teilweise ausfüllt.

Auf diese Weise wird im Gehäuseinneren eine Aufnahme für die Gehäuseabdichtung geschaffen, die vorteilhaft die Herstellung der Gehäuseabdichtung erleichtert und die Stabilität des Gehäuses und der Gehäuseabdichtung erhöht.

Bei dem erfindungsgemäßen Verfahren zum Abdichten eines Gehäuses für eine elektronische Schaltungsanordnung wird das Gehäuse gehäuseinnenseitig mit einer Gehäuseabdichtung abgedichtet. Die Gehäuseabdichtung wird stoffschlüssig mit wenigstens einer Gehäuseaußenwand verbunden und weist wenigstens einen Abdichtungsbereich auf, der aus einem Elastomer besteht, wobei das Elastomer aus einem Flüssigsilikon spritzgegossen wird.

Gleichzeitig wird dabei ein Spalt zwischen einer Gehäuseaußenwand und einem elektrischen Verbindungselement, das von dem Gehäuseinneren durch eine Gehäuseaußenwand hindurch aus dem Gehäuse herausgeführt ist, abgedichtet.

Durch die Gehäuseabdichtung wird ein Gehäuse mit den oben bereits genannten Vorteilen hergestellt. Die Herstellung der Elastomere durch Spritzgießen nutzt vorteilhaft die Eigenschaften von Flüssigsilikonen aus und ermöglicht die Herstellung geeignet ausgebildeter Gehäuseabdichtungen.

Eine erfindungsgemäße Getriebesteuerung umfasst ein erfindungsgemäßes Gehäuse mit einem aus ihm herausgeführten elektrischen Verbindungselement, eine in dem Gehäuse angeordnete elektronische Schaltungsanordnung und wenigstens eine außerhalb des Gehäuses angeordnete elektrische Komponente, wobei das wenigstens eine elektrische Verbindungselement des Gehäuses die elektronische Schaltungsanordnung mit wenigstens einer außerhalb des Gehäuses angeordneten elektrischen Komponente elektrisch verbindet.

Durch die Abdichtung des Gehäuses kann das Gehäuse dabei vorteilhaft direkt in einem Getriebe selbst verbaut werden, wodurch Bauraum und Kosten eingespart werden.

Dementsprechend weist ein erfindungsgemäßes Getriebe eine derartige Getriebesteuerung auf, wobei das Gehäuse der Getriebesteuerung in einem ein Getriebeöl enthaltenden Getriebeabschnitt angeordnet ist.

Dabei schützt das Gehäuse die elektronische Schaltungsanordnung vorteilhaft vor dem Getriebeöl.

Ausführungsbeispiele der Erfindung werden im Folgenden anhand von Zeichnungen näher erläutert.

Darin zeigen:
- Fig. 1: ein Gehäuse und eine darin angeordnete elektronische Schaltungsanordnung in einer Schnittdarstellung, und
- Fig. 2: ausschnittsweise ein erfindungsgemäßes Gehäuse mit einem elektrischen Verbindungselement und einer Gehäuseabdichtung in einer Schnittdarstellung.

Einander entsprechende Teile sind in den Figuren mit den gleichen Bezugszeichen versehen.

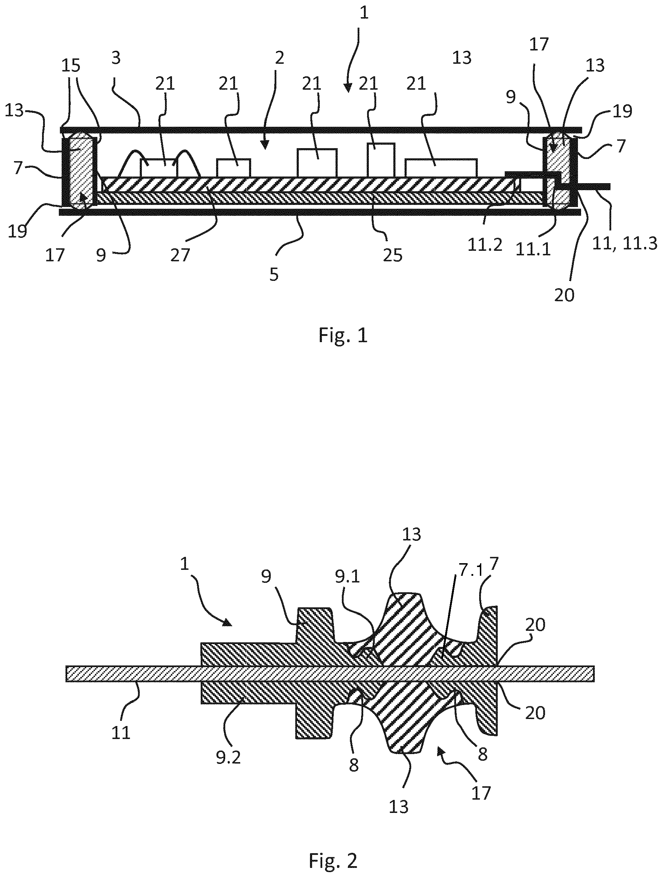

Fig. 1 zeigt schematisch ein Beispiel eines Gehäuses 1 und eine darin angeordnete elektronische Schaltungsanordnung 2 in einer Schnittdarstellung.

Das Gehäuse 1 weist Gehäuseaußenwände 3, 5, 7, eine Gehäuseinnenwand 9, ein elektrisches Verbindungselement 11 und eine Gehäuseabdichtung 13 auf.

Eine erste Gehäuseaußenwand 3 ist als Gehäusedeckel ausgebildet, eine zweite Gehäuseaußenwand 5 ist als Gehäuseboden ausgebildet, und eine dritte Gehäuseaußenwand 7 ist als Gehäuseseitenwand zwischen der ersten Gehäuseaußenwand 3 und der zweiten Gehäuseaußenwand 5 ausgebildet. Die Gehäuseinnenwand 9 verläuft im Gehäuseinneren parallel und benachbart zur dritten Gehäuseaußenwand 7 und bildet mit der dritten Gehäuseaußenwand 7 eine Doppelwand 15 des Gehäuses 1. Die Gehäuseinnenwand 9 und die dritte Gehäuseaußenwand 7 sind durch (nicht dargestellte) Stege fest miteinander verbunden und jeweils aus einem Kunststoff gefertigt.

Das elektrische Verbindungselement 11 ist als ein Stanzgitter ausgebildet und von dem Gehäuseinneren durch die Gehäuseinnenwand 9 und durch die dritte Gehäuseaußenwand 7 und damit durch die Doppelwand 15 hindurch aus dem Gehäuse 1 herausgeführt. In dem Gehäuseinneren ist das elektrische Verbindungselement 11 elektrisch mit der elektronischen Schaltungsanordnung 2 verbunden. In einem Zwischenraum 17 zwischen der dritten Gehäuseaußenwand 7 und der Gehäuseinnenwand 9 weist das elektrische Verbindungselement 11 einen Doppelknickbereich 11.1 auf, so dass ein gehäuseinnenseitiges Ende 11.2 des elektrischen Verbindungselementes 11 in einer Ebene verläuft, die gegenüber einer Ebene, in der ein gehäuseaußenseitiges Ende 11.3 des elektrischen Verbindungselementes 11 verläuft, parallel versetzt ist. Der Doppelknickbereich 11.1 erschwert vorteilhaft ein Verrutschen des elektrischen Verbindungselementes 11.

Die Gehäuseabdichtung 13 füllt den Innenraum der Doppelwand 15, d.h. den Zwischenraum 17 zwischen der dritten Gehäuseaußenwand 7 und der Gehäuseinnenwand 9, aus und erstreckt sich aus diesem Innenraum heraus bis zu der ersten Gehäuseaußenwand 3 und zu der zweiten Gehäuseaußenwand 5. Die Gehäuseabdichtung 13 ist stoffschlüssig mit den Gehäuseaußenwänden 3, 5, 7 und der Gehäuseinnenwand 9 verbunden, so dass die Gehäuseabdichtung 13 Wandlücken 19 zwischen der dritten Gehäuseaußenwand 7 und der ersten Gehäuseaußenwand 3 und zwischen der dritten Gehäuseaußenwand 7 und der zweiten Gehäuseaußenwand 5 abdichtet. Ferner umgibt die Gehäuseabdichtung 13 in dem Innenraum der Doppelwand 15 stoffschlüssig das elektrische Verbindungselement 11 und dichtet einen schmalen Spalt 20 zwischen der dritten Gehäuseaußenwand 7 und dem elektrischen Verbindungselement 11 ab.

Die Gehäuseabdichtung 13 besteht aus einem Elastomer, das aus einem Flüssigsilikon gefertigt wird. Das Elastomer besteht aus einem Flüssigsilikon mit einer Shore A-Härte im Bereich von 30-80.

Die elektronische Schaltungsanordnung 2 ist als eine Leiterplatte mit einer Grundplatte 25 ausgebildet, die ein Substrat 27 und darauf angeordnete elektronische Bauelemente 21 trägt.

Fig. 2 zeigt ausschnittsweise ein Ausführungsbeispiel eines Gehäuses 1 mit einem elektrischen Verbindungselement 11 und einer Gehäuseabdichtung 13 in einer Schnittdarstellung.

Das Gehäuse 1 des Ausführungsbeispiels weist ebenfalls Gehäuseaußenwände 3, 5, 7, eine Gehäuseinnenwand 9, ein elektrisches Verbindungselement 11 und eine Gehäuseabdichtung 13 auf, wobei eine erste Gehäuseaußenwand 3 als Gehäusedeckel ausgebildet ist, eine zweite Gehäuseaußenwand 5 als Gehäuseboden ausgebildet ist, und eine dritte Gehäuseaußenwand 7 als Gehäuseseitenwand ausgebildet ist. Die erste Gehäuseaußenwand 3 und die zweite Gehäuseaußenwand 5 sind analog zu dem in Fig. 1 dargestellten Beispiel ausgebildet und daher in Fig. 2 nicht noch einmal dargestellt. Ferner ist in dem Gehäuse 1 wie in dem Beispiel eine elektronische Schaltungsanordnung 2 angeordnet, die ebenfalls in Fig. 2 nicht dargestellt ist.

Das in Fig. 2 dargestellte Ausführungsbeispiel gemäß der Erfindung unterscheidet sich von dem in Fig. 1 dargestellten Beispiel durch die Ausbildungen der dritten Gehäuseaußenwand 7, der Gehäuseinnenwand 9, des elektrischen Verbindungselementes 11 und der Gehäuseabdichtung 13.

Das elektrische Verbindungselement 11 ist wie im in Fig. 1 dargestellten Beispiel von dem Gehäuseinneren durch die Gehäuseinnenwand 9 und durch die dritte Gehäuseaußenwand 7 hindurch aus dem Gehäuse 1 herausgeführt, weist im Unterschied jedoch in dem Zwischenraum 17 zwischen der dritten Gehäuseaußenwand 7 und der Gehäuseinnenwand 9 keinen Doppelknickbereich 11.1 auf, sondern ist dort im Wesentlichen plan ausgebildet.

Die dritte Gehäuseaußenwand 7 weist einen zapfenartig ausgebildeten Außenwandfortsatz 7.1 auf, der sich um das elektrische Verbindungselement 11 herum in den Zwischenraum 17 hinein erstreckt und eine ringförmig wenigstens teilweise um das elektrische Verbindungselement 11 herum verlaufende Rille 8 aufweist.

Die Gehäuseinnenwand 9 weist einen analog zu dem Außenwandfortsatz 7.1 ausgebildeten ersten Innenwandfortsatz 9.1 auf, der sich um das elektrische Verbindungselement 11 herum in den Zwischenraum 17 hinein erstreckt und eine ringförmig wenigstens teilweise um das elektrische Verbindungselement 11 herum verlaufende Rille 8 aufweist. Ferner weist die Gehäuseinnenwand 9 einen zweiten Innenwandfortsatz 9.2 auf, der sich um das elektrische Verbindungselement 11 herum zu der elektronischen Schaltungsanordnung 2 hin erstreckt und die Lage des elektrischen Verbindungselementes 11 vorteilhaft stabilisiert.

Die Gehäuseabdichtung 13 besteht aus einem Elastomer, das aus einem Flüssigsilikon gefertigt wird. Im Unterschied zum in Fig. 1 dargestellten Beispiel füllt die Gehäuseabdichtung 13 jedoch nicht den gesamten Zwischenraum 17 zwischen der dritten Gehäuseaußenwand 7 und der Gehäuseinnenwand 9 aus.

Die Gehäuseabdichtung 13 ist insbesondere stoffschlüssig mit dem Außenwandfortsatz 7.1, dem Innenwandfortsatz 9.1 und dem elektrischen Verbindungselement 11 verbunden und dichtet einen Spalt 20 zwischen der dritten Gehäuseaußenwand 7 und dem elektrischen Verbindungselement 11 ab.

Die Gehäuseabdichtung 13 füllt auch insbesondere die Rillen 8 in dem Außenwandfortsatz 7.1 und dem Innenwandfortsatz 9.1 aus, wodurch vorteilhaft die Verbindung der Gehäuseabdichtung 13 mit der Gehäuseinnenwand 9 und der dritten Gehäuseaußenwand 7 verbessert wird. Die Gehäuseabdichtung 13 erstreckt sich bis zu der ersten Gehäuseaußenwand 3 und der zweiten Gehäuseaußenwand 5, ist mit diesen stoffschlüssig verbunden und dichtet dadurch in Fig. 2 nicht dargestellte Wandlücken 19 (siehe Fig. 1) zwischen der dritten Gehäuseaußenwand 7 und der ersten Gehäuseaußenwand 3 und zwischen der dritten Gehäuseaußenwand 7 und der zweiten Gehäuseaußenwand 5 ab.

In den anhand der Figuren 1 und 2 beschriebenen Beispielen wird die Gehäuseabdichtung 13 in einem Spritzgießverfahren hergestellt, bei dem ein Flüssigsilikon in den Zwischenraum 17 zwischen der dritten Gehäuseaußenwand 7 und der Gehäuseinnenwand 9 eingespritzt wird. Die dritte Gehäuseaußenwand 7 und die Gehäuseinnenwand 9 bilden dabei einen Kunststoffrahmen für das Spritzgießen und befinden sich während des Einspritzens und anschließenden Aushärten des Flüssigsilikons in einem beheizten Werkzeug.

Die anhand der Figuren 1 und 2 beschriebenen Gehäuse 1 eignen sich insbesondere als Gehäuse 1 für eine elektronische Schaltungsanordnung 2 einer Getriebesteuerung eines Getriebes, wobei das Gehäuse 1 in einem ein Getriebeöl enthaltenden Getriebeabschnitt angeordnet ist und das elektrische Verbindungselement 11 die elektronische Schaltungsanordnung 2 mit wenigstens einer außerhalb des Gehäuses 1 angeordneten elektrischen Komponente der Getriebesteuerung, insbesondere mit einer elektrischen Energieversorgung für die elektronische Schaltungsanordnung 2, elektrisch verbindet. Die Gehäuseabdichtung 13 dichtet das Gehäuse 1 insbesondere gegenüber Getriebeöl des Getriebes ab und schützt somit die elektronische Schaltungsanordnung 2 vor dem Getriebeöl und anderen schädlichen Umwelteinflüssen.

### BEZUGSZEICHENLISTE

- 1: Gehäuse
- 2: elektronische Schaltungsanordnung
- 3: erste Gehäuseaußenwand
- 5: zweite Gehäuseaußenwand
- 7: dritte Gehäuseaußenwand
- 7.1: Außenwandfortsatz
- 8: Rille
- 9: Gehäuseinnenwand
- 9.1: erster Innenwandfortsatz
- 9.2: zweiter Innenwandfortsatz
- 11: elektrisches Verbindungselement
- 11.1: Doppelknickbereich
- 11.2: gehäuseinnenseitiges Ende
- 11.3: gehäuseaußenseitiges Ende
- 13: Gehäuseabdichtung
- 15: Doppelwand
- 17: Zwischenraum
- 19: Wandlücke
- 20: Spalt
- 21: elektronisches Bauelement
- 25: Grundplatte
- 27: Substrat

## Patentansprüche

1. Gehäuse (1) für eine elektronische Schaltungsanordnung (2), mit einer gehäuseinnenseitigen Gehäuseabdichtung (13), die stoffschlüssig mit wenigstens einer Gehäuseaußenwand (3, 5, 7) verbunden ist, wobei die Gehäuseabdichtung (13) aus einem Elastomer aus einem Flüssigsilikon besteht, wobei
ein elektrisches Verbindungselement (11) vom Gehäuseinneren durch eine Gehäuseaußenwand (3, 5, 7) hindurch aus dem Gehäuse (1) herausgeführt ist, und dass ein Spalt (20) zwischen dieser Gehäuseaußenwand (3, 5, 7) und dem elektrischen Verbindungselement (11) durch die Gehäuseabdichtung (13) abgedichtet ist,
indem die Gehäuseabdichtung (13) einen Zwischenraum (17) zwischen einer Gehäuseinnenwand (9) und der Gehäuseaußenwand (3, 5, 7) wenigstens teilweise ausfüllt und die Gehäuseabdichtung (13) mit der Gehäuseinnenwand (9) und der Gehäuseaußenwand (3, 5, 7)stoffschlüssig verbindet, **dadurch gekennzeichnet, dass**
a) die Gehäuseaußenwand (7), durch welche das elektrische Verbindungselement (11) geführt ist, einen zapfenartig ausgebildeten Außenwandfortsatz (7.1) aufweist, der sich um das elektrische Verbindungselement (11) herum in den Zwischenraum (17) hinein erstreckt und eine ringförmig wenigstens teilweise um das elektrische Verbindungselement (11) herum verlaufende Rille (8) aufweist,
b) die Gehäuseinnenwand (9), durch welche das elektrische Verbindungselement (11) geführt ist, einen analog zu dem Außenwandfortsatz (7.1) ausgebildeten ersten Innenwandfortsatz (9.1) aufweist, der sich um das elektrische Verbindungselement (11) herum in den Zwischenraum (17) hinein erstreckt und eine ringförmig wenigstens teilweise um das elektrische Verbindungselement (11) herum verlaufende Rille (8) aufweist, und
c) die Gehäuseabdichtung (13) die Rillen (8) in dem Außenwandfortsatz (7.1) und dem Innenwandfortsatz (9.1) ausfüllt.

2. Gehäuse (1) nach Anspruch 1, **dadurch gekennzeichnet, dass** das elektrische Verbindungselement (11) als ein Stanzgitter ausgebildet ist.

3. Gehäuse (1) nach Anspruch 1 oder 2, **dadurch gekennzeichnet, dass** das Elastomer aus einem Flüssigsilikon mit einer Shore A-Härte im Bereich von 30-80 besteht.

4. Gehäuse (1) nach einem der vorhergehenden Ansprüche, **dadurch gekennzeichnet, dass** die Gehäuseabdichtung (13) eine Wandlücke (19) zwischen Gehäuseaußenwänden (3, 5, 7) des Gehäuses (1) abdichtet.

5. Gehäuse (1) nach einem der vorhergehenden Ansprü**che,gekennzeichnet durch** die Gehäuseinnenwand (9) einen zweiten Innenwandfortsatz (9.2) aufweist, der sich um das elektrische Verbindungselement (11) herum zu der elektronischen Schaltungsanordnung (2) hin erstreckt.

6. Verfahren zum Abdichten eines Gehäuses (1) für eine elektronische Schaltungsanordnung (2), wobei das Gehäuse (1) gehäuseinnenseitig mit einer Gehäuseabdichtung (13) abgedichtet wird, die stoffschlüssig mit wenigstens einer Gehäuseaußenwand (3, 5, 7) verbunden wird und aus einem Elastomer besteht, wobei das Elastomer aus einem Flüssigsilikon spritzgegossen wird, und dabei ein Spalt (20) zwischen einer Gehäuseaußenwand (3, 5, 7) und einem elektrischen Verbindungselement (11), das von dem Gehäuseinneren durch eine Gehäuseaußenwand (3, 5, 7) hindurch aus dem Gehäuse (1) herausgeführt ist, abgedichtet wird, wobei die Gehäuseabdichtung (13) einen Zwischenraum (17) zwischen einer Gehäuseinnenwand (9) und der Gehäuseaußenwand (3, 5, 7) wenigstens teilweise ausfüllt und die Gehäuseabdichtung (13) mit der Gehäuseinnenwand (9) und der Gehäuseaußenwand (3, 5, 7) stoffschlüssig verbindet, **gekennzeichnet durch** die Schritte:
a) Bereitstellen der Gehäuseaußenwand (7), durch welche das elektrische Verbindungselement (11) geführt ist, mit einem zapfenartig ausgebildeten Außenwandfortsatz (7.1), der sich um das elektrische Verbindungselement (11) herum in den Zwischenraum (17) hinein erstreckt und eine ringförmig wenigstens teilweise um das elektrische Verbindungselement (11) herum verlaufende Rille (8) aufweist,
b) Bereitstellen der Gehäuseinnenwand (9), durch welche das elektrische Verbindungselement (11) geführt ist, mit einem analog zu dem Außenwandfortsatz (7.1) ausgebildeten ersten Innenwandfortsatz (9.1), der sich um das elektrische Verbindungselement (11) herum in den Zwischenraum (17) hinein erstreckt und eine ringförmig wenigstens teilweise um das elektrische Verbindungselement (11) herum verlaufende Rille (8) aufweist, und
c) Herstellen der Gehäuseabdichtung (13) so, dass die Gehäuseabdichtung (13) die Rillen (8) in dem Außenwandfortsatz (7.1) und dem Innenwandfortsatz (9.1) ausfüllt.

7. Getriebesteuerung mit einem Gehäuse (1) nach einem der Ansprüche 1 bis 5, einer in dem Gehäuse (1) angeordneten elektronischen Schaltungsanordnung (2) und wenigstens einer außerhalb des Gehäuses (1) angeordneten elektrischen Komponente, wobei das wenigstens eine elektrische Verbindungselement (11) des Gehäuses (1) die elektronische Schaltungsanordnung (2) mit wenigstens einer außerhalb des Gehäuses (1) angeordneten elektrischen Komponente elektrisch verbindet.

8. Getriebe mit einer Getriebesteuerung nach Anspruch 7, wobei das Gehäuse (1) der Getriebesteuerung in einem ein Getriebeöl enthaltenden Getriebeabschnitt angeordnet ist.

## Claims

1. Housing (1) for an electronic circuit arrangement (2) having a housing seal (13) that is on the inner face of the housing and is connected in an integrally bonded manner to at least one housing outer wall (3, 5, 7), wherein the housing seal (13) is embodied from an elastomer that is manufactured from a liquid silicone, wherein
an electrical connecting element (11) is guided out of the housing (1) from the housing interior through a housing outer wall (3, 5, 7), and a gap (20) between this housing outer wall (3, 5, 7) and the electrical connecting element (11) is sealed by means of the housing seal (13),
by way of the housing seal (13) filling an intermediate space (17) between a housing inner wall (9) and the housing outer wall (3, 5, 7) at least in part and the housing seal (13) connecting the housing inner wall (9) in an integrally bonded manner to the housing outer wall (3, 5, 7), **characterized in that**
a) the housing outer wall (7), through which the electrical connecting element (11) is guided, comprises a spigot-shaped outer wall extension (7.1) that extends around the electrical connecting element (11) into the intermediate space (17) and comprises a groove (8) that extends in an annular manner at least in part around the electrical connecting element (11),
b) the housing inner wall (9), through which the electrical connecting element (11) is guided, comprises a first inner wall extension (9.1) that is embodied in a similar manner to the outer wall extension (7.1) and extends around the electrical connecting element (11) into the intermediate space (17) and comprises a groove (8) that extends in an annular manner at least in part around the electrical connecting element (11), and
c) the housing seal (13) fills the grooves (8) in the outer wall extension (7.1) and the inner wall extension (9.1).

2. Housing (1) according to Claim 1, **characterized in that** the electrical connecting element (11) is embodied as a stamped grid.

3. Housing (1) according to Claim 1 or 2, **characterized in that** the elastomer is embodied from a liquid silicone that has a Shore A hardness in the range of 30-80.

4. Housing (1) according to any one of the preceding claims, **characterized in that** the housing seal (13) seals a wall space (19) between the housing outer walls (3, 5, 7) of the housing (1).

5. Housing (1) according to any one of the preceding claims, **characterized in that** the housing inner wall (9) comprises a second inner wall extension (9.2) that extends around the electrical connecting element (11) as far as the electronic circuit arrangement (2).

6. Method for sealing a housing (1) for an electronic circuit arrangement (2), wherein the housing (1) is sealed on the inner face of the housing by a housing seal (13) that is connected in an integrally bonded manner to at least one housing outer wall (3, 5, 7) and is embodied from an elastomer, wherein the elastomer is injection molded from a liquid silicone, and a gap (20) herein is sealed between a housing outer wall (3, 5, 7) and an electrical connecting element (11) that is guided out of the housing (1) from the housing interior through a housing outer wall (3, 5, 7), wherein the housing seal (13) fills an intermediate space (17) between a housing inner wall (9) and the housing outer wall (3, 5, 7) at least in part and the housing seal (13) connects the housing inner wall (9) in an integrally bonded manner to the housing outer wall (3, 5, 7),
**characterized by** the steps of:
a) providing the housing outer wall (7), through which the electrical connecting element (11) is guided, with a spigot-shaped outer wall extension (7.1) that extends around the electrical connecting element (11) into the intermediate space (17) and comprises a groove (8) that extends in an annular manner at least in part around the electrical connecting element (11),
b) providing the housing inner wall (9), through which the electrical connecting element (11) is guided, with a first inner wall extension (9.1) that is embodied in a similar manner to the outer wall extension (7.1) and extends around the electrical connecting element (11) into the intermediate space (17) and comprises a groove (8) that extends in an annular manner at least in part around the electrical connecting element (11), and
c) producing the housing seal (13) such that the housing seal (13) fills the grooves (8) in the outer wall extension (7.1) and the inner wall extension (9.1).

7. Transmission control device having a housing (1) according to any one of Claims 1 to 5, said transmission control device having an electronic circuit arrangement (2), which is arranged in the housing (1), and at least one electrical component that is arranged outside the housing (1), wherein the at least one electrical connecting element (11) of the housing (1) electrically connects the electronic circuit arrangement (2) to at least one electrical component that is arranged outside the housing (1).

8. Transmission having a transmission control device according to Claim 7, wherein the housing (1) of the transmission control device is arranged in a section of the transmission that contains transmission oil.

## Revendications

1. Boîtier (1) pour un ensemble de circuits électroniques (2), avec un joint d'étanchéité de boîtier (13) côté intérieur du boîtier, qui est matériellement assemblé à au moins une paroi extérieure de boîtier (3, 5, 7), dans lequel le joint d'étanchéité de boîtier (13) est constitué d'un élastomère en un silicone liquide, dans lequel un élément de connexion électrique (11) est conduit hors du boîtier (1) depuis l'intérieur du boîtier à travers une paroi extérieure de boîtier (3, 5, 7), et en ce qu'une fente (20) entre cette paroi extérieure de boîtier (3, 5, 7) et l'élément de connexion électrique (11) est rendue étanche par le joint d'étanchéité de boîtier (13), du fait que le joint d'étanchéité de boîtier (13) remplit au moins en partie un espace intermédiaire (17) entre une paroi intérieure de boîtier (9) et la paroi extérieure de boîtier (3, 5, 7) et le joint d'étanchéité de boîtier (13) relie matériellement le joint d'étanchéité de boîtier (13) à la paroi intérieure de boîtier (9) et à la paroi extérieure de boîtier (3, 5, 7),
**caractérisé en ce que**
a) la paroi extérieure de boîtier (7), à travers laquelle l'élément de connexion électrique (11) est conduit, présente un prolongement de paroi extérieure (7.1) réalisé en forme de tourillon, qui s'étend autour de l'élément de connexion électrique (11) dans l'espace intermédiaire (17) et présente une gorge (8) s'étendant sous forme d'anneau au moins partiellement autour de l'élément de connexion électrique (11),
b) la paroi intérieure de boîtier (9), à travers laquelle l'élément de connexion électrique (11) est conduit, présente un premier prolongement de paroi intérieure (9.1) de forme analogue au prolongement de paroi extérieure (7.1), qui s'étend autour de l'élément de connexion électrique (11) dans l'espace intermédiaire (17) et présente une gorge (8) s'étendant en forme d'anneau au moins partiellement autour de l'élément de connexion électrique (11), et
c) le joint d'étanchéité de boîtier (13) remplit les gorges (8) dans le prolongement de paroi extérieure (7.1) et le prolongement de paroi intérieure (9.1).

2. Boîtier (1) selon la revendication 1, **caractérisé en ce que** l'élément de connexion électrique (11) est réalisé sous la forme d'une grille découpée.

3. Boîtier (1) selon une revendication 1 ou 2, **caractérisé en ce que** l'élastomère se compose d'un silicone liquide avec une dureté Shore A comprise dans la plage 30 - 80.

4. Boîtier (1) selon l'une quelconque des revendications précédentes, **caractérisé en ce que** le joint d'étanchéité de boîtier (13) obture un vide de paroi (19) entre des parois extérieures de boîtier (3, 5, 7) du boîtier (1).

5. Boîtier (1) selon l'une quelconque des revendications précédentes, **caractérisé en ce que** la paroi intérieure de boîtier (9) présente un second prolongement de paroi intérieure (9.2), qui s'étend autour de l'élément de connexion électrique (11) en direction de l'ensemble de circuits électroniques (2).

6. Procédé d'étanchéification d'un boîtier (1) pour un ensemble de circuits électroniques (2), dans lequel le boîtier (1) est étanchéifié côté intérieur du boîtier avec un joint d'étanchéité de boîtier (13), qui est matériellement assemblé à au moins une paroi extérieure de boîtier (3, 5, 7) et qui se compose d'un élastomère, dans lequel l'élastomère en un silicone liquide est moulé par injection, et une fente (20) entre une paroi extérieure de boîtier (3, 5, 7) et un élément de connexion électrique (11), qui est conduit hors du boîtier (1) depuis l'intérieur du boîtier à travers une paroi extérieure de boîtier (3, 5, 7), est étanchéifiée,
dans lequel le joint d'étanchéité de boîtier (13) remplit au moins en partie un espace intermédiaire (17) entre une paroi intérieure de boîtier (9) et la paroi extérieure de boîtier (3, 5, 7) et relie matériellement le joint d'étanchéité de boîtier (13) à la paroi intérieure de boîtier (9) et à la paroi extérieure de boîtier (3, 5, 7),
**caractérisé par** les étapes suivantes:
a) préparer la paroi extérieure de boîtier (7), à travers laquelle l'élément de connexion électrique (11) est conduit, avec un prolongement de paroi extérieure (7.1) réalisé en forme de tourillon, qui s'étend autour de l'élément de connexion électrique (11) dans l'espace intermédiaire (17) et présente une gorge (8) s'étendant en forme d'anneau au moins partiellement autour de l'élément de connexion électrique (11),
b) préparer la paroi intérieure de boîtier (9), à travers laquelle l'élément de connexion électrique (11) est conduit, avec un premier prolongement de paroi intérieure (9.1) de forme analogue au prolongement de paroi extérieure (7.1), qui s'étend autour de l'élément de connexion électrique (11) dans l'espace intermédiaire (17) et présente une gorge (8) s'étendant en forme d'anneau au moins partiellement autour de l'élément de connexion électrique (11), et
c) réaliser le joint d'étanchéité de boîtier (13) de telle manière que le joint d'étanchéité de boîtier (13) remplisse les gorges (8) dans le prolongement de paroi extérieure (7.1) et dans le prolongement de paroi intérieure (9.1).

7. Commande de transmission avec un boîtier (1) selon l'une quelconque des revendications 1 à 5, avec un ensemble de circuits électroniques (2) disposé dans le boîtier (1) et avec au moins un composant électrique disposé à l'extérieur du boîtier (1), dans laquelle ledit au moins un élément de connexion électrique (11) du boîtier (1) relie électriquement l'ensemble de circuits électroniques (2) à au moins un composant électrique disposé à l'extérieur du boîtier (1).

8. Transmission avec une commande de transmission selon la revendication 7, dans laquelle le boîtier (1) de la commande de transmission est disposé dans une partie de transmission contenant une huile de transmission.
